# EUROPÄISCHE PATENTSCHRIFT

(11) **EP 2 918 544 B1**
(45) Veröffentlichungstag und Bekanntmachung des Hinweises auf die Patenterteilung: **10.05.2017**
(21) Anmeldenummer: 15155572.9
(22) Anmeldetag: 18.02.2015
(51) Int. Cl.: B81C 1/00

(54) **Vorrichtung zum Reduzieren eines (Partial-)Drucks zumindest einer chemischen Spezies in einer abgeschlossenen Kavität, Bauelement und Verfahren zum Herstellen des Bauelements**
Device for reducing a (partial) pressure of at least one chemical species in a closed cavity, component and method for production of the component
Dispositif destiné à réduire une pression (partielle) d'au moins une espèce chimique dans une cavité fermée, élément de construction et procédé de fabrication de l'élément de construction

(30) Priorität: 13.03.2014 DE 102014204666
(43) Veröffentlichungstag der Anmeldung: 16.09.2015
(73) Patentinhaber: ROBERT BOSCH GMBH, 70442 Stuttgart (DE)
(72) Erfinder: Schelling, Christoph, 70597 Stuttgart (DE)

(56) Entgegenhaltungen:
- EP-A1- 1 394 854
- DE-A1-102012 209 973
- US-A- 5 866 978

## Beschreibung

### Stand der Technik

Die vorliegende Erfindung bezieht sich auf ein Bauelement mit einer Vorrichtung zum Reduzieren eines Drucks zumindest einer chemischen Spezies in einer abgeschlossenen Kavität sowie auf ein Verfahren zum Herstellen des Bauelements.

Bei einem Bauelement kann in einer abgeschlossenen Kammer ein niedriger Druck erwünscht sein. Beispielsweise kann durch den niedrigen Druck eine geringe Dämpfung eines Sensorelements erreicht werden. Wenn mehrere Sensorelemente unterschiedlichen Typs in einem Bauelement kombiniert werden, kann es erforderlich sein, mehrere Kammern mit unterschiedlichen Drücken herzustellen.

Die US2010028618 beschreibt ein Verfahren, bei dem erst eine erste Kavität bei einem ersten Druck erzeugt und nachfolgend eine zweite Kavität bei einem zweiten Druck verschlossen wird.

Die EP 1 394 854 A1 beschreibt ein Verfahren zum Gettern von Kontaminationsstoffen in einem hermetisch abgeschlossen Raum. Dazu wird ein durch Hitze aktivierbarer Getter eingesetzt. Die US 5 866 978 A beschreibt ein internes Getterstrukturraster zum Einfangen eines sich in einem vakuumdichten Behälter befindlichen Gases.

DE 10 2012 209973 A1 offenbart ein Bauelement mit einer abgeschlossenen ersten Kavität, in der sich ein Widerstandsheizer und thermisch damit gekoppelter Getter befinden. In der Kavität ist ein mikroelektromechanisches Sensorelement angeordnet, welches thermisch von dem Getter entkoppelt ist. Das Bauelement weist zusätzlich eine weitere abgeschlossene Kavität auf, in der ein weiteres mikroelektromechanisches Sensorelement angeordnet ist, wobei die weitere Kavität von der ersten Kavität getrennt und in der weiteren Kavität kein Gettermaterial angeordnet ist.

### Offenbarung der Erfindung

Vor diesem Hintergrund werden mit dem hier vorgestellten Ansatz ein Bauelement mit einer Vorrichtung zum Reduzieren eines Drucks zumindest einer chemischen Spezies in einer abgeschlossenen Kavität sowie ein Verfahren zum Herstellen des Bauelements gemäß den Hauptansprüchen vorgestellt. Vorteilhafte Ausgestaltungen ergeben sich aus den jeweiligen Unteransprüchen und der nachfolgenden Beschreibung.

Eine dichte Kammer kann mit einem bestimmten Innendruck hergestellt werden, wenn während eines Verschließens der Kammer ein Druck an einem Produktionsort gleich dem gewünschten Innendruck ist. Dabei kann es wirtschaftlich und/oder technisch sinnvoll sein, den Druck höher einzustellen, als den gewünschten endgültigen Innendruck. Der endgültige Innendruck der Kammer kann dann durch ein Entziehen beziehungsweise Binden des Mediums in der Kammer eingestellt werden, nachdem die Kammer verschlossen wurde.

Das Entziehen kann durch Anordnen eines Gettermaterials in der Kammer vor dem Verschließen vorbereitet werden. Das Gettermaterial kann durch Wärmeeinwirkung aktiviert werden, nachdem die Kammer verschlossen worden ist. Die Wärmeenergie zum Aktivieren kann durch eine chemische, exotherme Reaktion zumindest zweier Edukte der Reaktion bereitgestellt werden, die in Wärme leitendem Kontakt zu dem Gettermaterial angeordnet worden sind.

Die Wärmeeinwirkung kann lokal begrenzt sein. Dadurch können empfindliche Strukturen und/oder Beschichtungen innerhalb der Kammer uneingeschränkt angeordnet werden.

Es wird eine Vorrichtung zum Reduzieren eines (Partial-)Drucks zumindest einer chemischen Spezies in einer abgeschlossenen Kavität vorgestellt, wobei die Vorrichtung die folgenden Merkmale aufweist:
einen Getter, der in der Kavität anordenbar ist und dazu ausgebildet ist, zumindest einen Anteil der Spezies aus der Kavität aufzunehmen, wenn der Getter innerhalb der Kavität auf eine Temperatur größer einer Aufnahmetemperatur erhitzt wird; und
einen chemischen Heizer, der thermisch mit dem Getter gekoppelt ist und dazu ausgebildet ist, durch eine selbsterhaltende exotherme Reaktion den Getter über die Aufnahmetemperatur zu erhitzen, wenn der Heizer mit einer Aktivierungsenergie aktiviert wird.

Unter einer chemischen Spezies können Atome oder Moleküle eines chemischen Elements oder einer chemischen Verbindung verstanden werden. Die Spezies kann flüssig oder gasförmig sein. Unter einem (Partial-)Druck, also einem Druck oder Partialdruck, kann ein Anteil der Spezies an einem Absolutdruck verstanden werden. Beispielsweise kann ein Sauerstoff-(Partial-)Druck beziehungsweise der (Partial-)Druck von Sauerstoff in Luft durch einen Verbrauch des Sauerstoffs reduziert werden, wobei ein Stickstoff-(Partial-)Druck beziehungsweise der (Partial-) Druck des Stickstoffs der Luft dabei unverändert bleibt. Wenn der Sauerstoff nicht durch ein anderes Gas ersetzt wird, verändert sich durch den reduzierten Sauerstoff-(Partial-)Druck der Absolutdruck der Luft in einem abgeschlossenen Volumen. Eine abgeschlossene Kavität kann eine fluiddichte Kammer beziehungsweise ein fluiddichter Hohlraum sein. Ein Getter kann als aktives Material ein Gettermaterial aufweisen. Der Getter kann eine Strukturkomponente umfassen. Das Gettermaterial kann eine chemische Spezies aufweisen, die geeignet ist, mit der zu reduzierenden Spezies eine chemische Verbindung zu bilden und die zu reduzierende Spezies damit zu binden. Die chemische Reaktion kann bei einer Temperatur größer der Aufnahmetemperatur stattfinden. Ein chemischer Heizer kann als aktives Material ein Heizermaterial aufweisen. Der Heizer kann ebenfalls eine Strukturkomponente umfassen. Die Strukturkomponente kann inert sein. Das Heizermaterial kann zumindest zwei chemische Spezies umfassen, die miteinander eine chemische Reaktion ausführen können, sobald eine Energie größer als die Aktivierungsenergie zugeführt wird. Bei der chemischen Reaktion zu zumindest einem Reaktionsprodukt kann thermische Energie freigesetzt werden. Die thermische Energie kann die Aktivierungsenergie für eine fortlaufende chemische Reaktion bereitstellen. Die freigesetzte thermische Energie ist größer als die Aktivierungsenergie. Dadurch wird netto thermische Energie zum Erhalten der chemischen Reaktion des Getters bereitgestellt.

Der Heizer kann mäanderförmig ausgebildet sein. Der Heizer kann an einem Anfang des Mäanders einen Startpunkt zum Einbringen der Aktivierungsenergie aufweisen. Ein Mäander kann als Schlangenlinie bezeichnet werden. Durch eine Mäanderform kann eine momentan reagierende Querschnittsfläche des Heizers vorbestimmt werden. Der Heizer kann dadurch fortlaufend reagieren. Eine momentan freigesetzte Energiemenge kann so begrenzt werden.

Weiterhin wird ein Bauelement mit einer abgeschlossenen Kavität vorgestellt, in der eine Vorrichtung zum Reduzieren eines (Partial-)Drucks zumindest einer chemischen Spezies in der Kavität angeordnet ist, wobei die Vorrichtung einen chemischen Heizer und einen Getter aufweist, der dazu ausgebildet ist, zumindest einen Anteil der Spezies aus der Kavität aufzunehmen, wenn der Getter innerhalb der Kavität auf eine Temperatur größer einer Aufnahmetemperatur erhitzt wird, wobei der Heizer thermisch mit dem Getter gekoppelt ist und dazu ausgebildet ist, durch eine selbsterhaltende exotherme Reaktion den Getter über die Aufnahmetemperatur zu erhitzen, wenn der Heizer mit einer Aktivierungsenergie aktiviert wird.

In der Kavität kann ein mikroelektromechanisches Sensorelement angeordnet sein. Das Sensorelement kann thermisch von der Vorrichtung zum Reduzieren entkoppelt sein. Das Sensorelement kann in der Kavität mit dem reduzierten Innendruck besonders effizient betrieben werden. Insbesondere kann das Sensorelement mit einem anderen Substrat gekoppelt sein, als die Vorrichtung zum Reduzieren des (Partial-)Drucks.

Das Bauelement kann eine weitere abgeschlossene Kavität aufweisen. In der weiteren Kavität kann ein weiteres mikroelektromechanisches Sensorelement angeordnet sein. Die weitere Kavität kann von der Kavität getrennt sein. In der weiteren Kavität kann ein anderer Innendruck eingestellt werden, als in der Kavität. Das weitere Sensorelement in der weiteren Kavität kann dadurch in anderen Umgebungsbedingungen betrieben werden als das Sensorelement.

Die Vorrichtung zum Reduzieren kann auf einem ersten Substrat des Bauelements angeordnet sein. Das erste Substrat kann im Bereich des Heizers ein Aktivierungselement zum Bereitstellen der Aktivierungsenergie aufweisen. Ein Aktivierungselement kann insbesondere ein elektrisches Heizelement sein. Das Aktivierungselement kann auf bzw. in eine elektrische Schaltung des Bauelements integriert sein. Dadurch kann das Bauelement kostengünstig hergestellt werden.

Ferner wird ein Verfahren zum Herstellen eines Bauelements gemäß dem hier vorgestellten Ansatz beschrieben, wobei das Verfahren die folgenden Schritte aufweist:
Bereitstellen eines ersten Substrats, eines zweiten Substrats und eines Verbindungsmaterials zum Verbinden der Substrate;
Abscheiden eines chemischen Heizermaterials auf dem ersten Substrat in zumindest einem für eine Kavität des Bauelements vorgesehenen Teilbereich des ersten Substrats, um einen chemischen Heizer auszubilden, wobei das Heizermaterial dazu ausgebildet ist, eine selbsterhaltende exotherme Reaktion auszuführen, wenn es mit einer Aktivierungsenergie aktiviert wird;
Anordnen eines Gettermaterials in thermischem Kontakt zu dem Heizer, um einen Getter auszubilden, wobei das Gettermaterial dazu ausgebildet ist, zumindest eine chemische Spezies aufzunehmen, wenn es auf eine Temperatur größer einer Aufnahmetemperatur erhitzt wird; und
Ausbilden der Kavität zwischen dem ersten Substrat und dem zweiten Substrat unter Verwendung des Verbindungsmaterials, wobei der Heizer und der Getter innerhalb der Kavität angeordnet werden und von einem abgeschlossenen Volumen innerhalb der Kavität umgeben sind.

Das Verfahren kann einen Schritt des Aktivierens der exothermen Reaktion des Heizers aufweisen. Der Schritt des Aktivierens kann ausgeführt werden, wenn die Kavität ausgebildet ist. Die Aktivierungsenergie kann durch ein Erwärmen des Heizers auf die Aktivierungstemperatur bereitgestellt werden. Der Heizer kann den Getter auf die Aufnahmetemperatur erhitzen, um zumindest einen Anteil der Spezies aus der Kavität aufzunehmen und einen (Partial-)Druck der Spezies in der Kavität zu reduzieren.

Das Heizermaterial kann in zumindest zwei unmittelbar benachbarten Lagen abgeschieden werden. Eine erste Lage kann zumindest ein erstes Edukt der Reaktion aufweisen. Eine zweite Lage kann zumindest ein zweites Edukt der Reaktion aufweisen. Aufeinanderfolgende Lagen können mit einer festgelegten Dicke abgeschieden werden. Dadurch kann ein Mengenverhältnis der Edukte, auch Reaktanden genannt, leicht festgelegt werden. Als Edukte kommen beispielweise Multilagensysteme aus z. B. zwei der folgenden Materialien Aluminium Al, Nickel Ni, Titan Ti, Niob Nb, Silizium Si, Zirkon Zr, Kohlenstoff C, Palladium Pd, Bor B in Frage. Insbesondere können Materialpaarungen von Al und Ni, Al und Ti, Nb und Si, Zr und Al, Ti und C, Pd und Al, TiB4C, Zr und Si verwendet werden. Die einzelnen Lagen der Mehrlagenschicht können mit einer Dicke von fünf bis 500 nm je Lage abgeschieden werden.

Das Heizermaterial kann ferner in einem Dichtungsbereich der Kavität abgeschieden werden. Der Dichtungsbereich kann ringförmig geschlossen umlaufend um den Teilbereich angeordnet sein. Durch Heizermaterial im Dichtungsbereich kann die thermische Energie beim Aktivieren des Heizers zum dichten Verbinden der Substrate verwendet werden.

Das Heizermaterial kann als durchgehende Schicht abgeschieden werden und in einem nachfolgenden Schritt des Strukturierens kann Heizermaterial entfernt werden, um zumindest den Heizer zu strukturieren. Eine durchgehende Schicht kann besonders einfach und schnell hergestellt werden.

Der hier vorgestellte Ansatz wird nachstehend anhand der beigefügten Zeichnungen beispielhaft näher erläutert. Es zeigen:
Fig. 1 ein Blockschaltbild einer Vorrichtung zum Reduzieren eines (Partial-)-Drucks gemäß einem Ausführungsbeispiel der vorliegenden Erfindung;
Fig. 2 eine Darstellung eines Bauelements mit zwei Kavitäten gemäß einem Ausführungsbeispiel der vorliegenden Erfindung vor einer Aktivierung eines Gettermaterials;
Fig. 3 eine Darstellung eines Bauelements mit reduziertem (Partial-) Druck in einer Kavität gemäß einem Ausführungsbeispiel der vorliegenden Erfindung;
Fig. 4 eine Darstellung eines Bauelements mit in den Schaltungsaufbau integriertem Heizer gemäß einem Ausführungsbeispiel der vorliegenden Erfindung;
Fig. 5 eine Detaildarstellung einer Vorrichtung zum Reduzieren eines (Partial-)-Drucks gemäß einem Ausführungsbeispiel der vorliegenden Erfindung;
Fig. 6 eine Darstellung eines Heizers in mäanderartiger Form gemäß einem Ausführungsbeispiel der vorliegenden Erfindung; und
Fig. 7 ein Ablaufdiagramm eines Verfahrens zum Herstellen eines Bauelements gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

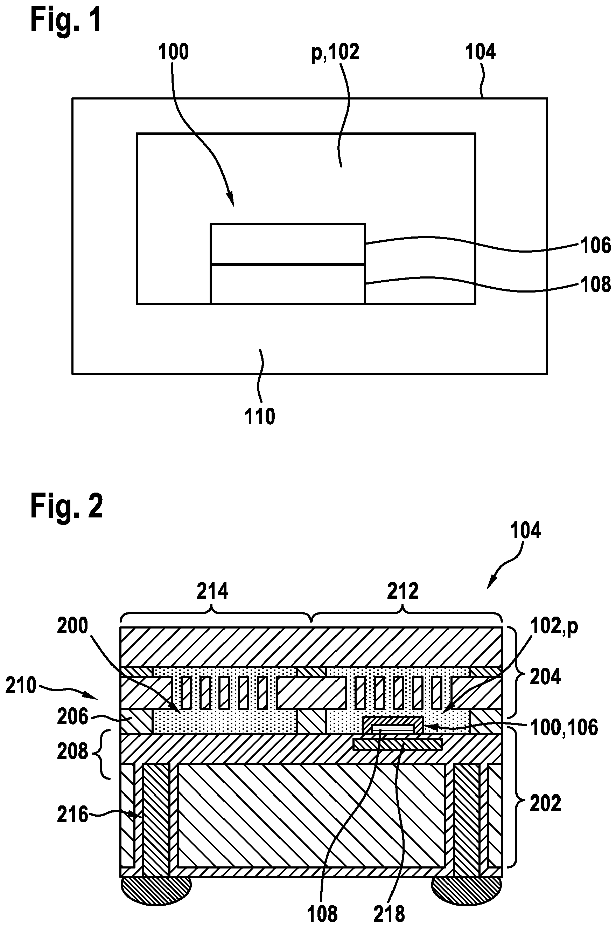

Fig. 1 zeigt ein Blockschaltbild einer Vorrichtung 100 zum Reduzieren eines (Partial-)Drucks p gemäß einem Ausführungsbeispiel der vorliegenden Erfindung. In diesem Ausführungsbeispiel ist die Vorrichtung 100 innerhalb einer Kavität 102 eines Bauelements 104 angeordnet. Die Vorrichtung 100 ist dazu ausgebildet, den (Partial-)Druck p zumindest einer chemischen Spezies in der abgeschlossenen Kavität 102 zu reduzieren. Die Vorrichtung weist einen Getter 106 aus einem Gettermaterial und einen chemischen Heizer 108 aus einem Heizermaterial auf. Der Getter 106 ist in der Kavität 102 angeordnet. Der Getter 106 ist dazu ausgebildet, zumindest einen Anteil der Spezies aus der Kavität 102 in dem Gettermaterial aufzunehmen, wenn der Getter 106 innerhalb der Kavität 102 auf eine Temperatur größer einer Aufnahmetemperatur erhitzt wird. Der chemische Heizer 108 ist thermisch mit dem Getter 106 gekoppelt. Der Heizer 108 ist an einer Wand 110 der Kavität 102 angeordnet. Der Heizer 108 ist dazu ausgebildet, durch eine selbsterhaltende exotherme Reaktion den Getter 106 über die Aufnahmetemperatur zu erhitzen. Zum Auslösen der Reaktion ist eine Aktivierungsenergie erforderlich.

Mit anderen Worten zeigt Fig. 1 ein monolithisch integriertes mikromechanisches Bauelement 104 mit mindestens einer hermetisch gedichteten Kavität 102, wobei die Kavität 102 zwischen zwei Substraten ausgebildet ist. Auf wenigstens einem Substrat ist eine Multilagenschicht 108 aus bevorzugt dünnen Lagen exotherm miteinander mischender Materialien und eine Getterschicht 106 übereinander aufgebracht.

Inertialstrukturen können mit einer Antihaftschicht beschichtet sein. Die Antihaftschicht unterbindet die natürliche Klebeneigung der Oberflächen der Siliziumstrukturen. Sie wird vor dem Bonden auf die MEMS-Strukturen aufgebracht, kann sich jedoch bereits bei Temperaturen oberhalb von 350°C zersetzen. Für die Aktivierung des Getters sind jedoch Temperaturen >350°C nötig. Die Verwendung der Antihaftschicht und die nachfolgende Aktivierung des Getters 108 können durch den hier vorgestellten Ansatz kombiniert werden.

Günstig ist es deshalb, wenn die Aktivierung des Getters 106 durch den integrierten Heizer und/oder eine exotherme Mischreaktion eines Multilagenstapels 108 erfolgt, der nur lokal eine hohe Temperatur erzeugt.

Besonders vorteilhaft ist es, wenn der Heizer 108 auf dem Auswerte-IC 104 integriert ist. Optimalerweise kann während des Testmessens des Sensors 104 der Getter 106 aktiviert werden und damit der Kaverneninnendruck reduziert werden.

Durch Einbringen des Gettermaterials 106 in die Kavität 102 kann der Druck nach einem Bondvorgang zum Herstellen der Kavität 102 nochmals erniedrigt werden. Für die Aktivierung des Gettervorgangs sind Temperaturen im Bereich größer 350°C notwendig. Durch den begrenzten Wärmeeintrag aus dem Heizer 108 wird eine Antihaftschicht innerhalb der Kavität 102 nicht beeinträchtigt.

Auf dem Substrat kann ein Heizer zur Zündung integriert sein.

In einem Substrat kann die Auswerteschaltung integriert sein.

In einem Substrat können MEMS-Inertialstrukturen integriert sein.

Die MEMS-Inertialstrukturen auf dem zweiten Substrat können Vorrichtungen zur Messung einer Beschleunigung und/oder einer Drehrate enthalten.

In dem Bauelement 104 können mindestens zwei Kavitäten 102 integriert sein, wobei sich in einer der Kavitäten 102 ein höherer Druck P2 befindet als in der anderen Kavität mit dem Druck P1.

Fig. 2 zeigt eine Darstellung eines Bauelements 104 mit zwei Kavitäten 102, 200 gemäß einem Ausführungsbeispiel der vorliegenden Erfindung. Das Bauelement 104 weist ein erstes Substrat 202, ein zweites Substrat 204 und einen Bondrahmen 206 als Verbindungseinrichtung 206 zwischen den Substraten 202, 204 auf. Die Kavitäten 102, 200 sind zwischen den Substraten 202, 204 angeordnet. Die Kavitäten 102, 200 erstrecken sich teilweise in das zweite Substrat 204. Die Kavitäten 102, 200 sind voneinander getrennt. Das erste Substrat 202 umfasst einen elektrischen Teil 208 des Bauelements 104. Das zweite Substrat 204 umfasst einen mechanischen Teil 210 des Bauelements 104. Der elektrische Teil 208 beziehungsweise die Schaltungsseite mit einer Auswerteschaltung 208 ist auf einer, den Kavitäten 102, 200 zugewandten Seite des ersten Substrats 202 angeordnet. Der mechanische Teil 210 umfasst im dargestellten Beispiel zwei mikroelektromechanische Inertialstrukturen 212, 214 beziehungsweise MEMS-Elemente 212, 214. Eine erste Inertialstruktur 212 ist in der ersten Kavität 102 angeordnet. Eine zweite Inertialstruktur 214 ist in der zweiten Kavität 200 angeordnet. Die erste Inertialstruktur 212 ist als Drehratensensorelement 212 ausgebildet. Die zweite Inertialstruktur 214 ist als Beschleunigungssensorelement 214 ausgebildet. Das erste Substrat 202 umfasst elektrisch leitende Strukturen 216 zum elektrischen Kontaktieren des elektrischen Teils 208.

In der ersten Kavität 102 ist eine Vorrichtung 100 zum Reduzieren eines (Partial-)Drucks p zumindest einer chemischen Spezies gemäß dem hier vorgestellten Ansatz angeordnet. Die Vorrichtung 100 entspricht im Wesentlichen der Vorrichtung in Fig. 1 und weist einen Getter 106 sowie einen Heizer 108 auf. Der Heizer 108 liegt mit einer Fläche an dem ersten Substrat 202 an. Anders als in Fig. 1 umschließt der Getter 106 den Heizer 108 an allen freiliegenden Flächen. Der Heizer 108 ist hier als Multilagenschicht 108 ausgebildet, in der eine Mehrzahl von abwechselnden Lagen übereinander geschichtet sind. Die einzelnen Lagen beinhalten die Edukte der exothermen Reaktion zum Bereitstellen der Aufnahmetemperatur. Die Lagen sind unmittelbar aufeinander abfolgend abgeschieden worden. Zum Auslösen der exothermen Reaktion ist im ersten Substrat 202 ferner ein elektrisches Heizelement 218 als Aktivierungselement 218 integriert. Das Heizelement 218 ist dazu ausgebildet, die Aktivierungsenergie zum Auslösen der selbsterhaltenden Reaktion in Form von Wärmeenergie bereitzustellen. Wenn die Reaktion gestartet ist, läuft die Reaktion irreversibel ab, bis ein Abbruchkriterium erfüllt ist. Beispielsweise kann als Abbruchkriterium eine Konzentration der Edukte unter eine Reaktionsschwelle gesunken sein. Im Idealfall werden die Edukte in stöchiometrischem Verhältnis bereitgestellt. Dann kann die Reaktion bis zur vollständigen Umsetzung der Edukte in Reaktionsprodukte ablaufen. Danach hört die Reaktion von alleine auf. Die Sensorelemente 212, 214 sind thermisch von der Vorrichtung 100 zum Reduzieren entkoppelt.

Die Multilagenschicht 108 kann aus einem der Materialien Aluminium Al, Nickel Ni, Titan Ti, Niob Nb, Silizium Si, Zirkon Zr, Kohlenstoff C, Palladium Pd, Bor B bestehen. Insbesondere können Materialpaarungen von Al und Ni, Al und Ti, Nb und Si, Zr und Al, Ti und C, Pd und Al, TiB4C, Zr und Si verwendet werden. Die einzelnen Lagen der Mehrlagenschicht können mit einer Dicke von fünf bis 500 nm je Lage abgeschieden werden.

Beschleunigungssensoren 214 sollen möglichst gasgedämpft sein, damit sie nicht zur freien Schwingung neigen und damit nicht vorhandene Beschleunigungen vorgaukeln. Drehratensensoren 212 dagegen sollen eine möglichst hohe Schwingergüte besitzen, was zu einem scharfen Resonanzpeak, einer geringen Leistungsaufnahme und einer hohen Empfindlichkeit führt. Beschleunigungssensoren 214 benötigen daher eher hohe Kaverneninnendrücke, während Drehratensensoren 212 eher niedrige Kaverneninnendrücke erfordern. Um für beide Sensoren 212, 214 einen jeweils günstigen Druck p erreichen zu können, werden die Sensoren 212, 214 in zwei voneinander getrennten Kavernen 102, 200 untergebracht und nach dem Bonden wird in einer der Kavernen 102 der beim Bonden eingeschlossene Druck p nachträglich verändert.

Beim Bonden lassen sich minimale Drücke in der Größenordnung von einigen mbar in den Kavernen 102, 200 einschließen, wobei die Restgasatmosphäre zumeist aus Stickstoff oder Argon jeweils mit Wasserstoff besteht. Für eine weitere Reduktion der Kaverneninnendrücke p wird ein Gettermaterial 106 in die Kaverne 102 des Drehratensensors 212 eingebracht und bei Temperaturen oberhalb von 350°C durch Aufheizen des (Gesamt-)Bauelements aktiviert.

Weitere Möglichkeiten zur lokalen Erzeugung einer hohen Temperatur sind die Nutzung der Reaktionswärme einer Festkörperreaktion, wie z. B. Mischungswärme von Al/Ti-, Ni/Al- and Nb/Si- oder ähnlichen Multilagen 108. Die Mischreaktion kann mittels Laser oder eines integrierten Heizers an einem Punkt gezündet werden und durchläuft dann das gesamte Volumen der Multilagen 108, erhitzt die lokale Umgebung und aktiviert damit den Getter 106. Dabei kann es günstig sein, wenn die Multilagen 108 und/oder der Getter 106 mäanderförmig ausgebildet sind und der Getter 106 im Wesentlichen dieselbe Dicke wie der Multilagenstapel 108 besitzt. Zur Vermeidung eines überhöhten Wärmeeintrags in das Substrat 202 kann der Multilagenstapel 108 mit dem Getter 106 als Membran oberhalb der Schaltung 208 ausgebildet sein.

Die Aktivierung des Getters 106 kann mit einem reaktiven Bonden kombiniert werden. Dabei kann das Bonden der Substrate 202, 204 und das Aktivieren des Getters 106 gleichzeitig erfolgen. Die Multilagen 108 dienen in diesem Fall auch als Wärmelieferant für das Bondverbindungsmaterial. In diesem Fall kann der Getter 106 in einem Bereich außerhalb des Bondbereichs 206 auf die Multilagen 108 aufgebracht sein. In einem Ausführungsbeispiel verläuft eine Zündlunte vom Bondrahmen 206 zur getterbelegten Fläche 108.

Alternativ kann ein fokussierter (Infrarot-)Laserstrahl optional in Verbindung mit einer Absorberschicht beispielsweise aus SiO2 zur lokalen Erhitzung und damit Getteraktivierung genutzt werden.

Mit anderen Worten zeigt Fig. 2 einen Inertialsensorcluster 104 mit mehreren Freiheitsgraden (Degrees of Freedom). Der Inertialsensorcluster 104 ist als beispielhafter Querschnitt durch das Bauelement 104 vor dem Zünden der Mischreaktion dargestellt.

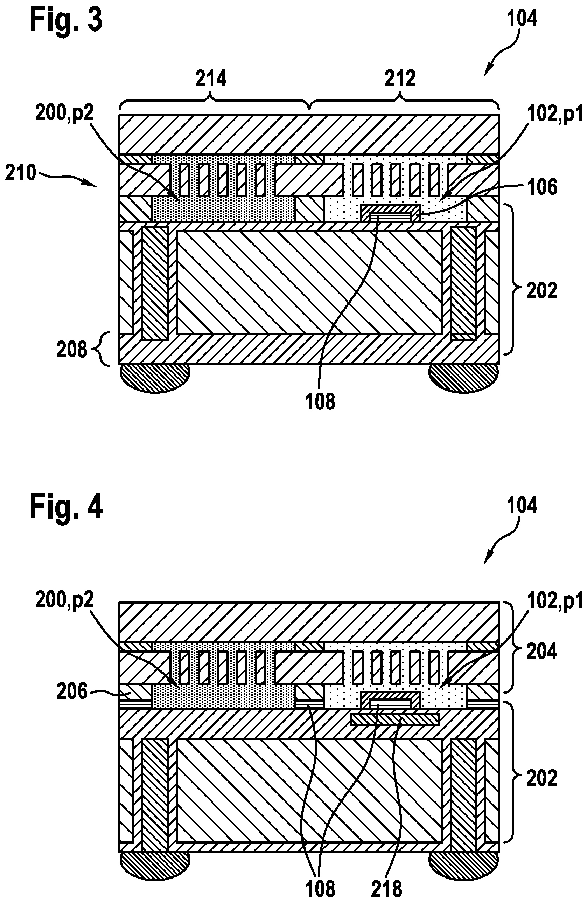

Fig. 3 zeigt eine Darstellung eines Bauelements 104 mit reduziertem (Partial-)Druck p2 in einer ersten Kavität 102 gemäß einem Ausführungsbeispiel der vorliegenden Erfindung. Das Bauelement 104 entspricht im Wesentlichen dem Bauelement in Fig. 2. Hier ist der chemische Heizer 108 in ausreagiertem Zustand, also nach der exothermen Reaktion dargestellt. Die in Fig. 1 dargestellten Edukte sind unter Wärmeabgabe während der exothermen Reaktion zu Reaktionsprodukten ausreagiert. Durch die Reaktion ist der Getter 106 auf seine Aufnahmetemperatur erhitzt worden. Oberhalb der Aufnahmetemperatur ist zumindest ein Anteil zumindest einer chemischen Spezies in der ersten Kavität 102 in dem Gettermaterial des Getters 106 gebunden worden. Durch das Binden, also das Immobilisieren der Spezies ist der (Partial-)Druck p2 der Spezies gegenüber ihrem Ausgangs-(partial)druck p reduziert worden. In der zweiten Kavität 200 herrscht weiterhin derselbe Druck p1, bei dem die Kavitäten 102, 200 verschlossen worden sind. Durch den niedrigeren Druck p2 in der ersten Kavität 102 wird das mikroelektromechanische Element 210 weniger in seinen Schwingungen gedämpft, als das mikroelektromechanische Element 210 in der zweiten Kavität 200.

Das hier dargestellte Bauelement 104 unterscheidet sich von dem in Fig. 2 dargestellten Bauelement durch das Fehlen eines elektrischen Heizelements zum Auslösen der exothermen Reaktion. Die Aktivierungsenergie ist hier von außen zugeführt worden.

Monolithisch hochintegrierte mikromechanische Inertialbauelemente 212, 214 zur Messung von sowohl Beschleunigung als auch Drehrate erfordern für eine optimale Funktionsweise zwei Kavernen 102, 200 mit unterschiedlichen Drücken p1, p2. Für den Beschleunigungssensor 214 wird bevorzugt ein höherer Innendruck p2 in der Kaverne 200 eingestellt, um für eine ausreichende Dämpfung zu sorgen, während für den angetriebenen Drehratensensor 212 eine möglichst hohe Schwingergüte durch niedrigen Druck p1 eingestellt wird.

Der mit dem hier vorgestellten Verfahren in der Kavität 102 erzeugbare minimale Druck p1 ergibt sich aus der Getterfläche und seiner Effizienz sowie der Größe der Kavität 102.

Fig. 4 zeigt eine Darstellung eines Bauelements 104 mit durchgehendem Heizer 108 gemäß einem Ausführungsbeispiel der vorliegenden Erfindung. Das Bauelement 104 entspricht im Wesentlichen dem Bauelement in Fig. 2. Zusätzlich ist hier das Heizermaterial 108 auch in einem Dichtungsbereich zwischen dem Bondrahmen 206 und dem ersten Substrat 202 angeordnet. Der Dichtungsbereich ist ringförmig geschlossen umlaufend um die Kavitäten 102, 200 angeordnet. Dadurch wird während der exothermen Reaktion des Heizermaterials 108 eine Energie zum Bonden des Bondrahmens 206 mit den Substraten 202, 204 bereitgestellt. Der Prozess des Bondens und der Prozess des Reduzierens des (Partial-)Drucks p in der ersten Kavität 102 laufen also parallel ab. Da in der zweiten Kavität 200 kein Gettermaterial angeordnet ist, wird der (Partial-) Druck p1 dort nicht reduziert.

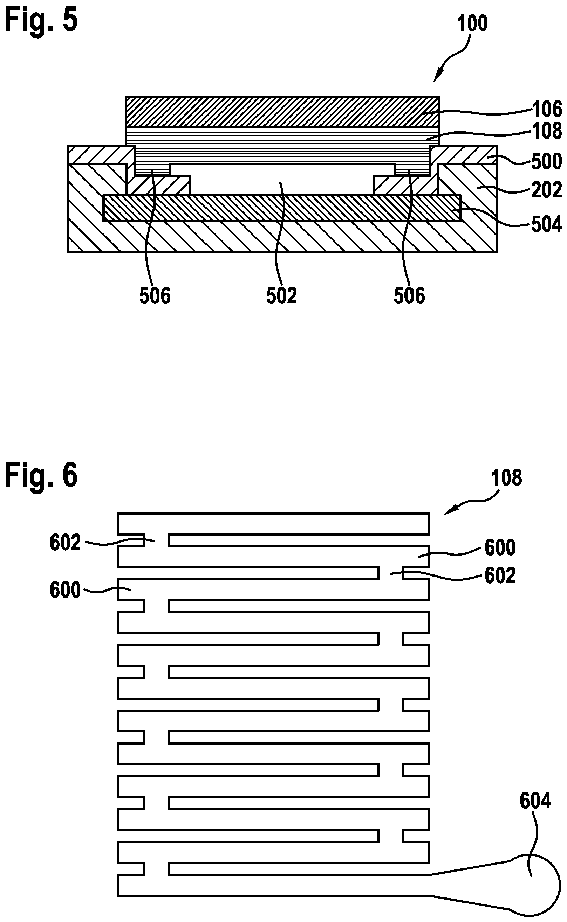

Fig. 5 zeigt eine Detaildarstellung einer Vorrichtung 100 zum Reduzieren eines (Partial-)Drucks gemäß einem Ausführungsbeispiel der vorliegenden Erfindung. Wie in Fig. 1 weist die Vorrichtung 100 einen Getter 106 und einen Heizer 108 auf. Die Vorrichtung 100 ist wie in den Figuren 2 bis 4 auf dem ersten Substrat 202 angeordnet. Das Substrat 202 weist mehrere Schichten auf. Das (Halbleiter-)Substrat 202 umfasst mehrere Lagen Dielektrika 202 und Metallisierungen 504. Eine Deckschicht 500 des Substrats 202 ist als eine Passivierung 500 ausgebildet. Die Passivierung 500 umfasst hier Siliziumnitrid SiN. Das Substrat 202 weist im Bereich des Heizers 108 eine Vertiefung 502 auf. Der Heizer 108 ist teilweise versenkt in der Vertiefung 502 angeordnet. Der Heizer 108 steht teilweise über die Vertiefung 502 über. Am Boden der Vertiefung 502 ist eine Metallisierung 504 in dem Dielektrikum angeordnet. In der Vertiefung 502 ist die Passivierung 500 teilweise durchbrochen, wodurch die Metallisierung 504 freiliegt. Die Metallisierung 504 dient als Reflektor für die Wärmestrahlung. Der Heizer 108 ist hier mit einer verringerten Auflagefläche auf dem ersten Substrat 202 ausgebildet, um einen verringerten Wärmeübergang von dem Heizer in das Substrat zu erreichen. Dazu weist der Heizer 108 Füßchen 506 auf, die als Abstandshalter zu dem Substrat 202 ausgebildet sind. Die Füßchen 506 liegen in der Vertiefung 502 auf der Passivierung 500 auf. Zwischen dem Heizer 108 und der Metallisierung 504 ist ein isolierender Spalt ausgebildet.

Mit anderen Worten ist die Vorrichtung 100 zum Reduzieren als aufgehängte Multilagen-Getter-Struktur 100 beziehungsweise Multilagen-Getter-Stapel 100 ausgebildet.

Fig. 6 zeigt eine Darstellung eines Heizers 108 in mäanderartiger Form gemäß einem Ausführungsbeispiel der vorliegenden Erfindung. Der Heizer 108 weist eine Vielzahl von parallel zueinander angeordneten, voneinander beabstandeten, gleich langen Streifen 600 aus Heizermaterial 108 auf. Jeweils benachbarte Streifen 600 sind durch einen Verbindungssteg 602 aus dem Heizermaterial 108 miteinander verbunden. Der Heizer 108 ist als Kette von Streifen 600 und Verbindungsstegen 602 ausgebildet. Ein Verbindungssteg 602 verbindet zwei Streifen 600 in einem Endbereich der Streifen 600. Der Verbindungssteg 602 ist von einem Ende der Streifen 600 geringfügig zurückversetzt. Die Streifen 600 weisen also an den Enden überstehende Fortsätze auf. Ein Streifen 600 ist durch einen ersten Verbindungssteg 602 mit einem vorhergehenden Streifen 600 der Kette verbunden. Der Streifen 600 ist einem zweiten Verbindungssteg 602 mit einem nachfolgenden Streifen 600 der Kette verbunden. Der erste Verbindungssteg 602 ist auf einer, dem zweiten Verbindungssteg 602 gegenüberliegenden Seite des Streifens 600 angeordnet. An einem Anfang der Kette ist ein Zündpunkt 604 beziehungsweise Startpunkt 604 angeordnet. An dem Zündpunkt wird beim Aktivieren des Heizers 108 die Aktivierungsenergie eingebracht, um die exotherme Reaktion zu starten. Die Reaktion verläuft anschließend vom Anfang der Kette durch die Kette bis zu einem Ende der Kette. Der Zündpunkt 604 kann beispielsweise unter Verwendung von Laserenergie erwärmt werden, bis die Aktivierungsenergie erreicht worden ist.

Auch die Getterschicht kann als Mäander strukturiert sein.

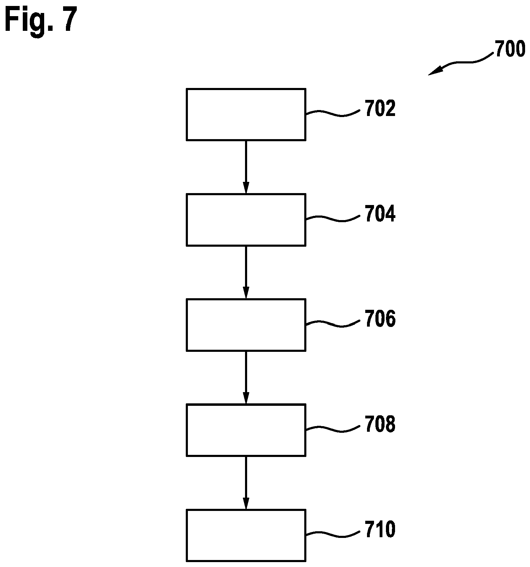

Fig. 7 zeigt ein Ablaufdiagramm eines Verfahrens 700 zum Herstellen eines Bauelements gemäß einem Ausführungsbeispiel der vorliegenden Erfindung. Das Verfahren 700 weist einen Schritt 702 des Bereitstellens, einen Schritt 704 des Abscheidens, einen Schritt 706 des Anordnens und einen Schritt 708 des Ausbildens auf. Im Schritt 702 des Bereitstellens werden ein erstes Substrat, ein zweites Substrat und eine Verbindungseinrichtung zum Verbinden der Substrate bereitgestellt. Im Schritt 704 des Abscheidens wird ein chemisches Heizermaterial auf dem ersten Substrat in zumindest einem für eine Kavität des Bauelements vorgesehenen Teilbereich des ersten Substrats abgeschieden, um einen chemischen Heizer auszubilden. Das Heizermaterial ist dazu ausgebildet, eine selbsterhaltende exotherme Reaktion auszuführen, wenn es mit einer Aktivierungsenergie aktiviert wird. Im Schritt 706 des Anordnens wird ein Gettermaterial in thermischem Kontakt zu dem Heizer angeordnet, um einen Getter auszubilden. Das Gettermaterial ist dazu ausgebildet, zumindest eine chemische Spezies aufzunehmen, wenn es auf eine Temperatur größer einer Aufnahmetemperatur erhitzt wird. Im Schritt 708 des Ausbildens wird die Kavität zwischen dem ersten Substrat und dem zweiten Substrat unter Verwendung der Verbindungseinrichtung ausgebildet. Der Heizer und der Getter werden innerhalb der Kavität angeordnet und sind von einem abgeschlossenen Volumen innerhalb der Kavität umgeben.

In einem Ausführungsbeispiel weist das Verfahren einen Schritt 710 des Aktivierens der exothermen Reaktion des Heizers auf. Der Schritt 710 wird ausgeführt, wenn die Kavität ausgebildet ist. Dabei wird die Aktivierungsenergie durch ein zumindest partielles Erwärmen des Heizers auf die Aktivierungstemperatur bereitgestellt. Die resultierende exotherme Reaktion des Heizers erhitzt den Getter auf die Aufnahmetemperatur, um zumindest einen Anteil der Spezies aus der Kavität aufzunehmen und einen (Partial-)Druck der Spezies in der Kavität zu reduzieren.

Mit anderen Worten wird im Schritt 710 eine Getteraktivierung durch lokale Wärmeerzeugung beschrieben.

Der hier vorgestellte Ansatz beschreibt ein Verfahren 700 zur Reduzierung von Kaverneninnendrücken in hermetisch dichten Kavitäten eines monolithischen MEMS-Bauelements, beispielsweise eines Inertialmesselements mit sechs Freiheitsgraden. Das Verfahren 700 ist insbesondere kompatibel mit Antihaftschichten.

Das in Fig. 7 beschriebene Verfahren 700 zur Reduzierung von Drücken in hermetisch gedichteten Kavitäten eines monolithischen MEMS-Bauelements kann einen Schritt 702 des Bereitstellens, einen Schritt 704 des Bereitstellens, einen Schritt 708 des Ausbildens und einen Schritt 710 des Zündens aufweisen. Im Schritt 702 des Bereitstellens werden ein erstes Kappensubstrat und ein zweites MEMS-Substrat bereitgestellt. Im Schritt 704 des Abscheidens wird eine Multilagenschicht aus bevorzugt dünnen Lagen exotherm miteinander mischender Materialien und Strukturieren auf wenigstens einem der beiden Substrate abgeschieden. Im Schritt 708 des Ausbildens werden die hermetisch gegeneinander gedichteten Kavitäten durch einen Bondvorgang des Kappenelements und des MEMS-Elements bei einem minimalen gewünschten Bonddruck ausgebildet. Im Schritt 710 des Zündens wird der exotherme, selbsterhaltende Mischungsvorgang in der Multilagenschicht gezündet.

In einem Ausführungsbeispiel erfolgt das Zünden 710 durch ein transientes beziehungsweise kurzfristiges Erhitzen desjenigen Elements, auf dem der Getter strukturiert ist.

In einem Ausführungsbeispiel erfolgt das Zünden 710 durch einen auf dem gettertragenden Substrat integrierten Heizer. Dabei kann das Zünden 710 auch beispielsweise während des Abgleichs erfolgen.

In einem Ausführungsbeispiel erfolgt das Zünden 710 durch einen Laser oder über eine Heizplatte, wobei die Aktivierungsenergie von extern eingebracht wird.

Dadurch können beide Inertialmesselemente bei ihrem jeweils optimalen Druck betrieben werden.

Das hier beschriebene Verfahren ist kompatibel mit Antihaftbeschichtungen.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Bauelement (104) mit einer abgeschlossenen Kavität (102), in der eine Vorrichtung (100) zum Reduzieren eines Drucks (p) zumindest einer chemischen Spezies in der Kavität (102) angeordnet ist, wobei die Vorrichtung (100) einen Heizer (108) und einen Getter (106) aufweist, der dazu ausgebildet ist, zumindest einen Anteil der Spezies aus der Kavität (102) aufzunehmen, wenn der Getter (106) innerhalb der Kavität (102) auf eine Temperatur größer einer Aufnahmetemperatur erhitzt wird, wobei der Heizer (108) thermisch mit dem Getter (106) gekoppelt ist und in der Kavität (102) ein mikroelektromechanisches Sensorelement (212) angeordnet ist, wobei das Sensorelement (212) thermisch von der Vorrichtung (100) zum Reduzieren des Drucks einer Spezies entkoppelt ist und das Bauelement (104) eine weitere abgeschlossene Kavität (200) aufweist, in der ein weiteres mikroelektromechanisches Sensorelement (214) angeordnet ist, wobei die weitere Kavität (200) von der Kavität (102) getrennt ist und in der weiteren Kavität (200) kein Gettermaterial angeordnet ist, **dadurch gekennzeichnet, dass** der Heizer (108) ein chemischer Heizer und dazu ausgebildet ist, durch eine selbsterhaltende exotherme Reaktion den Getter (106) über die Aufnahmetemperatur zu erhitzen, wenn der Heizer (108) mit einer Aktivierungsenergie aktiviert wird.

2. Bauelement (104) gemäß einem der vorangegangenen Ansprüche, bei dem die Vorrichtung (100) zum Reduzieren auf einem ersten Substrat (202) des Bauelements (104) angeordnet ist, wobei das erste Substrat (202) im Bereich des Heizers (108) ein Aktivierungselement (218) zum Bereitstellen der Aktivierungsenergie aufweist.

3. Verfahren (700) zum Herstellen eines Bauelements (104) gemäß einem der vorangegangenen Ansprüche, wobei das Verfahren (700) die folgenden Schritte aufweist:
Bereitstellen (702) eines ersten Substrats (202), eines zweiten Substrats (204) und eines Verbindungsmaterials (206) zum Verbinden der Substrate (202, 204);
Abscheiden (704) eines chemischen Heizermaterials (108) auf dem ersten Substrat (202) in zumindest einem für eine Kavität (102) des Bauelements (104) vorgesehenen Teilbereich des ersten Substrats (202), um einen chemischen Heizer (108) auszubilden, wobei das Heizermaterial (108) dazu ausgebildet ist, eine selbsterhaltende exotherme Reaktion auszuführen, wenn es mit einer Aktivierungsenergie aktiviert wird;
Anordnen (706) eines Gettermaterials (106) in thermischem Kontakt zu dem Heizer (108), um einen Getter (106) auszubilden, wobei das Gettermaterial (106) dazu ausgebildet ist, zumindest eine chemische Spezies aufzunehmen, wenn es auf eine Temperatur größer einer Aufnahmetemperatur erhitzt wird; und
Ausbilden (708) der Kavität (102) und einer weiteren Kavität (200) zwischen dem ersten Substrat (202) und dem zweiten Substrat (204) unter Verwendung des Verbindungsmaterials (206), wobei der Heizer (108) und der Getter (106) innerhalb der Kavität (102) angeordnet werden und von einem abgeschlossenen Volumen innerhalb der Kavität (102) umgeben sind, und wobei die weitere Kavität (200) von der Kavität (102) getrennt ist und in der weiteren Kavität (200) kein Gettermaterial angeordnet ist.

4. Verfahren (700) gemäß Anspruch 3, mit einem Schritt (710) des Aktivierens der exothermen Reaktion des Heizers (108), wenn die Kavität (102) ausgebildet ist, wobei die Aktivierungsenergie durch ein Erwärmen des Heizers (108) auf die Aktivierungstemperatur bereitgestellt wird, und der Heizer (108) den Getter (106) auf die Aufnahmetemperatur erhitzt, um zumindest einen Anteil der Spezies aus der Kavität (102) aufzunehmen und einen Druck (p) der Spezies in der Kavität (102) zu reduzieren.

5. Verfahren (700) gemäß einem der vorangegangenen Ansprüche, bei dem im Schritt (704) des Abscheidens das Heizermaterial (108) in zumindest zwei unmittelbar benachbarten Lagen abgeschieden wird, wobei eine erste Lage zumindest ein erstes Edukt der Reaktion aufweist und eine zweite Lage zumindest ein zweites Edukt der Reaktion aufweist.

6. Verfahren (700) gemäß einem der vorangegangenen Ansprüche, bei dem im Schritt (704) des Abscheidens das Heizermaterial (108) ferner in einem Dichtungsbereich der Kavität (102) abgeschieden wird, wobei der Dichtungsbereich ringförmig geschlossen umlaufend um die Kavität (102) angeordnet ist.

## Claims

1. Component (104) with a closed cavity (102), arranged in which is a device (100) for reducing a pressure (p) of at least one chemical species in the cavity (102), the device (100) having a heater (108) and a getter (106), which is designed to take up at least a fraction of the species from the cavity (102) when the getter (106) within the cavity (102) is heated to a temperature greater than a take-up temperature, the heater (108) being thermally coupled to the getter (106) and a micro-electromechanical sensor element (212) being arranged in the cavity (102), the sensor element (212) being thermally decoupled from the device (100) for reducing the pressure of a species and the component (104) having a further closed cavity (200), in which a further micro-electromechanical sensor element (214) is arranged, the further cavity (200) being separate from the cavity (102) and no getter material being arranged in the further cavity (200), **characterized in that** the heater (108) is a chemical heater and is designed to heat the getter (106) above the take-up temperature by a self-sustaining exothermic reaction when the heater (108) is activated by activation energy.

2. Component (104) according to one of the preceding claims, in which the reducing device (100) is arranged on a first substrate (202) of the component (104), the first substrate (202) having in the region of the heater (108) an activation element (218) for providing the activation energy.

3. Method (700) for producing a component (104) according to one of the preceding claims, the method (700) comprising the following steps:
providing (702) a first substrate (202), a second substrate (204) and a connecting material (206) for connecting the substrates (202, 204);
depositing (704) a chemical heater material (108) on the first substrate (202) in at least a partial region of the first substrate (202) that is intended for a cavity (102) of the component (104), in order to form a chemical heater (108), the heater material (108) being designed to carry out a self-sustaining exothermic reaction when it is activated by activation energy;
arranging (706) a getter material (106) in thermal contact with the heater (108) in order to form a getter (106), the getter material (106) being designed to take up at least one chemical species when it is heated to a temperature greater than a take-up temperature; and
forming (708) the cavity (102) and a further cavity (200) between the first substrate (202) and the second substrate (204) by using the connecting material (206), the heater (108) and the getter (106) being arranged within the cavity (102) and surrounded by a closed volume within the cavity (102), and the further cavity (200) being separate from the cavity (102) and no getter material being arranged in the further cavity (200).

4. Method (700) according to Claim 3, comprising a step (710) of activating the exothermic reaction of the heater (108) when the cavity (102) has been formed, the activation energy being provided by heating of the heater (108) to the activation temperature, and the heater (108) heating the getter (106) to the take-up temperature in order to take up at least a fraction of the species from the cavity (102) and reduce a pressure (p) of the species in the cavity (102).

5. Method (700) according to one of the preceding claims, in which in the depositing step (704) the heater material (108) is deposited in at least two directly adjacent layers, a first layer having at least a first reactant of the reaction and a second layer having at least a second reactant of the reaction.

6. Method (700) according to one of the preceding claims, in which in the depositing step (704) the heater material (108) is also deposited in a sealing region of the cavity (102), the sealing region being arranged in an annually closed form, running around the cavity (102).

## Revendications

1. Composant (104) comportant une cavité fermée (102) dans laquelle est disposé un dispositif (100) destiné à réduire une pression (p) d'au moins une espèce chimique dans la cavité (102), dans lequel le dispositif (100) comporte un élément chauffant (108) et un piège (106) qui est réalisé de manière à absorber au moins une partie de l'espèce à partir de la cavité (102) lorsque le piège (106) est chauffé à l'intérieur de la cavité (102) à une température supérieure à une température d'absorption, dans lequel l'élément chauffant (108) est couplé thermiquement au piège (106) et un élément capteur microélectromécanique (212) est disposé dans la cavité (102), dans lequel l'élément capteur (212) est découplé thermiquement du dispositif (100) destiné à réduire la pression d'une espèce et le composant (104) comporte une autre cavité fermée (200) dans laquelle est disposé un autre élément capteur microélectromécanique (214), dans lequel l'autre cavité (200) est séparée de la cavité (102) et aucun matériau de piège n'est disposé dans l'autre cavité (200), **caractérisé en ce que** l'élément chauffant (108) est un élément chauffant chimique et est réalisé de manière à chauffer le piège (106) par une réaction exothermique autoentretenue au-dessus de la température d'absorption lorsque l'élément chauffant (108) est activé avec une énergie d'activation.

2. Composant (104) selon l'une quelconque des revendications précédentes, dans lequel le dispositif (100) destiné de réduction est disposé sur un premier substrat (202) du composant (104), dans lequel le premier substrat (202) comporte dans la région de l'élément chauffant (108) un élément d'activation (218) destiné à fournir de l'énergie d'activation.

3. Procédé (700) de fabrication d'un composant (104) selon l'une quelconque des revendications précédentes, dans lequel le procédé (700) comporte les étapes consistant à :
fournir (702) un premier substrat (202), un deuxième substrat (204) et un matériau de liaison (206) destiné à lier les substrats (202, 204) ;
déposer (704) un matériau chimique d'élément chauffant (108) sur le premier substrat (202) dans au moins une section du premier substrat (202) prévue pour une cavité (102) du composant (104), afin de réaliser un élément chauffant chimique (108), dans lequel le matériau d'élément chauffant (108) est conçu de manière à produire une réaction exothermique autoentretenue lorsqu'il est activé avec une énergie d'activation ;
disposer (706) un matériau de piège (106) en contact thermique avec l'élément chauffant (108) pour réaliser un piège (106), dans lequel le matériau de piège (106) est conçu manière à absorber au moins une espèce chimique lorsqu'il est chauffé à une température supérieure à une température d'absorption ; et
réaliser (708) la cavité (102) et une autre cavité (200) entre le premier substrat (202) et le deuxième substrat (204) par utilisation du matériau de liaison (206), dans lequel l'élément chauffant (108) et le piège (106) sont disposés à l'intérieur de la cavité (102) et sont entourés par un volume fermé à l'intérieur de la cavité (102), et dans lequel l'autre cavité (200) est séparée de la cavité (102) et aucun matériau de piège n'est disposé dans l'autre cavité (200).

4. Procédé (700) selon la revendication 3, comportant une étape (710) consistant à activer la réaction exothermique de l'élément chauffant (108) lorsque la cavité (102) est réalisée, dans lequel l'énergie d'activation est fournie par chauffage de l'élément chauffant (108) à la température d'activation, et l'élément chauffant (108) chauffe le piège (106) à la température d'absorption afin d'absorber au moins une partie de l'espèce à partir de la cavité (102) et de réduire une pression (p) de l'espèce dans la cavité (102).

5. Procédé (700) selon l'une quelconque des revendications précédentes, dans lequel, lors de l'étape (704) d'activation, le matériau d'élément chauffant (108) est déposé dans au moins deux positions directement voisines, dans lequel une première position comporte au moins un premier produit de départ de la réaction et une deuxième position comporte au moins un deuxième produit de départ de la réaction.

6. Procédé (700) selon l'une quelconque des revendications précédentes, dans lequel, lors de l'étape (704) d'activation, le matériau d'élément chauffant (108) est en outre déposé dans une région d'étanchéité de la cavité (102), dans lequel la région d'étanchéité est disposée circonférentiellement sur le pourtour de la cavité (102) sous la forme d'un anneau fermé.
